# EUROPEAN PATENT APPLICATION

(11) **EP 3 761 766 A1**
(43) Date of publication of application: **06.01.2021**
(21) Application number: 19184254.1
(22) Date of filing: 03.07.2019
(51) Int. Cl.: H05K 3/06

(54) **ANISOTROPIC ETCHING USING ADDITIVES**

(71) Applicant: AT & S Austria Technologie & Systemtechnik Aktiengesellschaft, 8700 Leoben-Hinterberg (AT)
(72) Inventor: Klocek, Jolanta, 8700 Leoben (AT); Krivec, Thomas, 8740 Zeltweg (AT); Resch, Martina, 8042 Graz (AT); Steinberger, Anke, 8741 Weißkirchen (AT)
(74) Representative: Dilg, Haeusler, Schindelmann Patentanwaltsgesellschaft mbH

(57) **Abstract**

An etching composition for etching an electrically conductive layer structure for forming a conductor track is provided which comprises an etchant, an etching additive comprising a polymer compound, an organic substance comprising a polyhydric compound and optionally a solvent. In addition, a method of etching an electrically conductive layer structure, a conductor track, and a component carrier are provided.

## Description

The invention relates to an etching composition, a method of etching an electrically conductive layer structure (hereinafter, also simply referred to as an "etching process"), a conductor track, and a component carrier.

In the context of growing product functionalities of component carriers equipped with one or more components and increasing miniaturization of such components as well as a rising number of components to be mounted on component carriers such as printed circuit boards (PCBs), increasingly more powerful array-like components or packages having several components are being employed, which have a plurality of contacts or connections, with ever smaller spacing between these contacts.

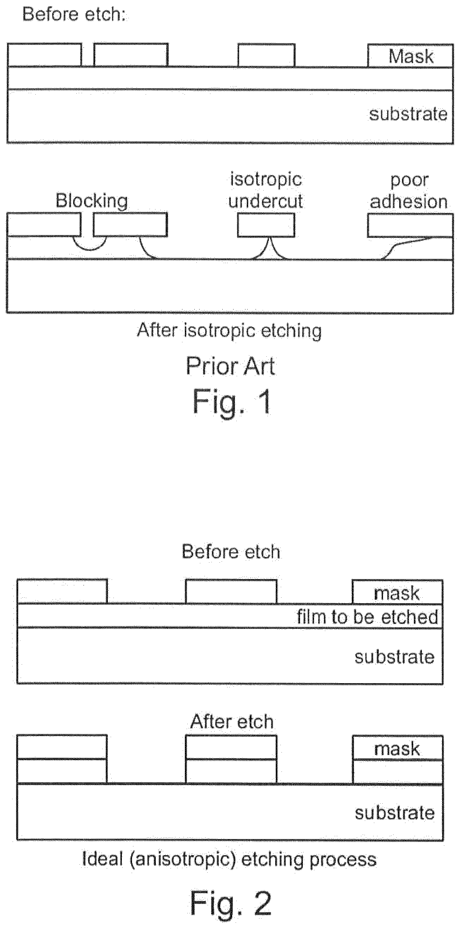

The PCB industry is in particular confronted with the task to adapt the size of the produced printed circuit boards to comply with the miniaturization requirements. Due to the new dimensions of the circuit paths, drill holes and their distance from each other, it is necessary to implement new etching techniques, in particular new copper etching processes. Although the copper etching process is one of the most important steps in the manufacture of printed circuit boards, processing of copper during fabrication is still a challenging task. In a conventional isotropic copper etching process as shown in Figure 1, when a copper film to be etched formed on a substrate and partly covered by a mask (as a negative template for patterning) is etched, undercuts may be formed beneath the mask due to isotropic etching, resulting in poor adhesion. In addition, isotropic etching may not be capable of forming very fine etching structures, but isotropic etching may be blocked by respective, fine masks structures.

The generation of fine structures with circuit paths of 30 microns and below may require an anisotropic etching process. In case of printed circuit boards, it is desired that the etching (in particular the copper removal) occurs more in the vertical direction rather than in the lateral direction. Hereby, regular structures may be obtained and short cuts may be avoided. An ideal anisotropic etching process is shown in Figure 2, wherein the etching exclusively occurs in the vertical direction, but not in the lateral direction of the PCB so that no undercuts are formed.

It is an object of the invention to provide an etching composition and an etching process allowing an anisotropic etching of an electrically conductive layer structure and/or allowing the formation of a conductor track having a substantially regular shape, in particular with substantially vertical side walls, thereby increasing the overall quality of a component carrier, such as a printed circuit board. It is a further object that the etching composition is substantially not hazardous to human health and to the environment.

In order to achieve the objects defined above, an etching composition, a method of etching an electrically conductive layer structure, a conductor track, and a component carrier according to the independent claims are provided.

According to an exemplary embodiment of the invention, an etching composition for etching an electrically conductive layer structure for forming a conductor track is provided which comprises an etchant (an etching agent), a an etching additive comprising a polymer compound (which may have surface-active properties and may thus also be referred to as surfactant additive), an (biocompatible, non-toxic) organic substance comprising a polyhydric compound (in particular polyhydric alcohol or sugar alcohol) and optionally a solvent.

According to another exemplary embodiment of the invention, a method of etching an electrically conductive layer structure of a component carrier for forming a conductor track is provided, wherein the method comprises subjecting the electrically conductive layer structure to an etching composition as described herein.

According to still another exemplary embodiment of the invention, a conductor track is provided, wherein a virtual tangent at a lower edge of a side wall of the conductor track and a virtual tangent at an upper edge of the side wall of the conductor track intersect with each other at a virtual intersection point, wherein a height of the virtual intersection point is at least 40 % of a total height of the conductor track. In an embodiment, the conductor track may be formed by means of an etching composition as described herein and/or by the method of etching as described herein.

According to yet another exemplary embodiment of the invention, a conductor track is provided, wherein a ratio between an upper width and a central width is in a range between 1.0 and 1.3 and a ratio between a central width and a lower width is in a range between 0.6 and 1.0. In an embodiment, the conductor track may be formed by means of an etching composition as described herein and/or by the method of etching as described herein.

According to yet another exemplary embodiment of the invention, a component carrier is provided which comprises a stack of at least one electrically insulating layer structure and at least one electrically conductive layer structure, wherein at least a part of at least one electrically conductive layer structure comprises a conductor track as described herein.

In the context of the present application, the term "etching composition" may particularly denote a fluid, such as a solution or a liquid, which is capable of at least partly etching (dissolving) an electrically conductive material, such as a metal, in particular - but not limited to - copper, aluminum, nickel or silver. To this end, the etching composition may in particular comprise an etchant (etching agent) representing a reactive component of the composition substantially responsible for the at least partly etching (dissolving) an electrically conductive material.

According to an exemplary embodiment of the invention, an etching composition is provided comprising specific additives which promote an anisotropic etching of an electrically conductive layer structure so that conductor tracks may be formed having a substantially regular shape, in particular with substantially vertical side walls. Without wishing to be bound to any theory, it is believed that the etching additive and/or the organic substance, in particular the polymer compound comprised, may adsorb at (adhere to) the surface of the side walls of a recess (cavity) formed in the electrically conductive layer structure during etching, thereby protecting or shielding the side walls from the etchant and suppressing a further etching in a lateral direction. In addition, it is believed that the polymer compound and/or the polyhydric compound contained in the etching composition may provide for a shear thinning/pseudoplastic behavior and/or a viscosity-optimizing effect, which may further increase the anisotropy of the etching process. As a result, an etching in a vertical direction may be promoted compared with an etching in a lateral direction. Hereby, the overall quality of a component carrier, such as a printed circuit board, may be increased, in particular in terms of a decreased defect rate as well as an improved etching distribution within the produced boards and a higher etching factor of etched structures.

In the following, further exemplary embodiments of the etching composition, the method of etching an electrically conductive layer structure, the conductor track, and the component carrier will be explained. However, the present invention is not limited to the following specific descriptions of exemplary embodiments, but they are rather for illustrative purposes only.

It should be noted that features described in connection with one exemplary embodiment or exemplary aspect may be combined with any other exemplary embodiment or exemplary aspect, in particular features described with any exemplary embodiment of an etching composition may be combined with any other exemplary embodiment of an etching composition and any exemplary embodiment of a method of etching an electrically conductive layer structure, a conductor track, and a component carrier and vice versa, unless specifically stated otherwise.

Where an indefinite or definite article is used when referring to a singular term, such as "a", "an" or "the", a plural of that term is also included and vice versa, unless specifically stated otherwise, whereas the word "one" or the number "1", as used herein, typically means "just one" or "exactly one".

It should be noted that the term "comprising" does not exclude other elements or steps and, as used herein, includes not only the meaning of "comprising", "including" or "containing", but also encompasses "consisting essentially of" and "consisting of".

Unless specifically stated otherwise, the expressions "at least partially", "at least partly", "at least part of" or "at least a part of", as used herein, may mean at least 1 % thereof, in particular at least 5 % thereof, in particular at least 10 % thereof, in particular at least 15 % thereof, in particular at least 20 % thereof, in particular at least 25 % thereof, in particular at least 30 % thereof, in particular at least 35 % thereof, in particular at least 40 % thereof, in particular at least 45 % thereof, in particular at least 50 % thereof, in particular at least 55 % thereof, in particular at least 60 % thereof, in particular at least 65 % thereof, in particular at least 70 % thereof, in particular at least 75 % thereof, in particular at least 80 % thereof, in particular at least 85 % thereof, in particular at least 90 % thereof, in particular at least 95 % thereof, in particular at least 98 % thereof, and may also include 100 % thereof.

In an embodiment, the etching composition is a solution or a liquid. Such etching composition may be suitably used in a wet etching process. The etching composition may be prepared by dissolving the various ingredients, such as an etchant, an etching additive and an organic substance, in an appropriate solvent, such as water and/or an organic solvent.

In an embodiment, the etchant comprises at least one of cupric chloride (CuCl₂) and ferric chloride (FeCl₃) and may optionally further comprise at least one of hydrochloric acid (HCl) and hydrogen peroxide (H₂O₂). Alternatively, an alkaline etchant may be employed, too. It might be advantageous that the etchant comprises cupric chloride (CuCl₂), which may be combined with hydrochloric acid (HCl) and/or hydrogen peroxide (H₂O₂), in particular when the etching composition is intended for etching an electrically conductive layer structure for forming a conductor track of a component carrier.

In an embodiment, the etching composition comprises an etching additive configured for suppressing an etching of side walls of a recess formed in the electrically conductive layer structure during etching.

In an embodiment, the etching additive comprises a polymer compound. In the context of the present application, the term "polymer compound" may particularly denote an organic compound having a (weight-average) molecular weight of at least 1,000 g/mol, in particular at least 2,500 g/mol, in particular at least 5,000 g/mol, in particular at least 10,000 g/mol, and typically not more than 1,000,000 g/mol, such as not more than 500,000 g/mol. The polymer compound may include one or more types of repeating units, derived from respective monomers. Thus, the term "polymer compound" may also include a copolymer compound or a mixture of polymer and copolymer compounds.

In an embodiment, the polymer compound may be configured for adsorbing at the surface of a side wall of a recess formed in the electrically conductive layer structure during etching. Thus, the polymer compound may be configured for protecting or shielding the side walls from the etchant and suppressing a further etching in a lateral direction.

In an embodiment, the polymer compound may be configured for providing a shear thinning/pseudoplastic behavior to the etching composition. Thus, the polymer compound may be configured for promoting the anisotropy of the etching process.

In an embodiment, the polymer compound (of the etching additive) comprises at least one of a phosphor atom, a nitrogen atom and/or a sulphur atom. In particular, the polymer compound may comprise one or more functional groups containing a phosphor atom, a nitrogen atom and/or a sulphur atom. A polymer compound comprising such functional group may additionally protect or shield the side walls (of a recess formed in the electrically conductive layer structure during etching) from the etchant and may suppress that the etching proceeds in a lateral direction.

In an embodiment, the polymer compound (of the etching additive) is a homopolymer having a repeating unit comprising a heterocycle, in particular a non-aromatic or (at least partly or fully) saturated heterocycle. For instance, the polymer may comprise a (for instance aliphatic) backbone chain to which residues comprising a heterocycle are bound. In the context of the present application, the term "heterocycle" may in particular denote a cyclic structure (ring structure) having atoms of at least two different elements as members of the ring, for instance carbon and at least one other element, such as nitrogen, sulfur and/or oxygen. In an embodiment, the heterocycle may comprise carbon and nitrogen as members of its ring. In an embodiment, the heterocycle may comprise a five- or six-membered ring. In an embodiment, the heterocycle may comprise one or more further functional groups or substituents.

In an embodiment, the etching additive is selected from the group consisting of polyacrylamide, polyacrylic acid, polymethacrylic acid, polymethylmethacrylate, polyvinyl alcohol, polyvinyl acetate, polylactic acid, polyglycolic acid, polyvinylpyridine, polyvinylpyrrolidone, poly(N-vinylformamide), polyoxazoline, polyethylene oxide, polyetheretherketone, cellulose ether, carboxymethyl cellulose, gelatin, collagen, chitosan, and dextran. These compounds may be particularly suitable for adsorbing at the surface of a side wall of a recess formed in the electrically conductive layer structure during etching and/or for providing a shear thinning/pseudoplastic behavior to the etching composition, thereby promoting the anisotropy of the etching process.

In an embodiment, the etching additive or the polymer compound may also possess surface-active properties. In other words, the etching additive may act as a surfactant and may thus also be referred to as a surfactant additive. Alternatively or additionally, it may also be possible that the etching composition further comprises a surfactant additive in addition to the etching additive.

In an embodiment, the surfactant additive is at least one selected from the group consisting of an anionic surfactant, a cationic surfactant, a nonionic surfactant and a zwitterionic surfactant. In particular, the surfactant additive may be at least one selected from the group consisting of an anionic surfactant, a cationic surfactant and a nonionic surfactant. More specifically, the surfactant additive may be at least one of an anionic surfactant and a cationic surfactant and even more specifically the surfactant additive may comprise an anionic surfactant.

In an embodiment, the surfactant additive is configured for promoting (facilitating) a material exchange during etching and/or for accelerating movement of bubbles from a surface. To this end, the surfactant additive may have appropriate functional groups. Thus, the surfactant additive may comprise functional groups (configured for) promoting a material exchange during etching and/or (for) accelerating movement of bubbles from a surface.

In an embodiment, the etching additive (or the polymer compound) is contained in the etching composition in a concentration of from 0.001 g/l to 10 g/l, in particular of from 0.01 g/l to 5 g/l.

In an embodiment, the organic substance comprises a polyhydric compound, in particular a polyhydric alcohol (which may also be referred to as a sugar alcohol).

In the context of the present application, the term "polyhydric compound" may particularly denote an organic compound containing two or more hydroxy groups, such as two, three, four, five or more hydroxy groups.

In an embodiment, the polyhydric compound comprises two, three, four, five or six carbon atoms.

In an embodiment, the number of carbon atoms and the number of hydroxy groups is the same in the polyhydric compound. In particular, the polyhydric compound may have the chemical formula HOCH₂(CHOH)ₙCH₂OH, wherein n is an integer of from 2 to 6, such as 3 or 4.

In an embodiment, the organic substance is selected from the group consisting of ethylene glycol, glycerin, erythritol, threitol, arabinol, xylitol, ribitol, mannitol, sorbitol, galacticol and polyglycitol. These compounds may exhibit an advantageous combination of physical and chemical properties, compatibility with many other substances and easy handling, which makes them particularly suitable for use as the organic substance. In addition, they are substantially nontoxic to human health and to the environment.

In an embodiment, the organic substance or the polyhydric compound may be configured for adsorbing at the surface of a side wall of a recess formed in the electrically conductive layer structure during etching and/or for adjusting (in particular optimizing) the viscosity of the etching composition.

In an embodiment, the organic substance is contained in the etching composition in a concentration of from 0.001 g/l to 5 g/l, in particular of from 0.01 g/l to 3 g/l.

In an embodiment, the etching composition comprises a solvent, such as water and/or an organic solvent. In an embodiment, the solvent allows for a (substantially complete) dissolution of the various ingredients of the etching composition, such as the etchant, the etching additive and the organic substance.

In an embodiment, the etching composition further comprises a rheological additive. In the context of the present application, the term "rheological additive" may particularly denote a compound capable of modifying the rheological behavior of the etching composition, preferably a compound exhibiting a shear thinning/pseudoplastic effect. The rheological additive may comprise an organic compound and/or an inorganic compound.

In an embodiment, the rheological additive is selected from the group consisting of silica, hydroxyethyl cellulose, phyllosilicates and urea. The silica may in particular be a hydrophilic and/or pyrogenic and/or amorphous silica, such as HDK N20 (commercially available from Wacker Chemie AG, München, Germany). The hydroxyethyl cellulose may in particular be a water-soluble hydroxyethyl cellulose, such as Natrosol 250 HHBR or Natrosol 250 HHX (commercially available from Ashland Inc., Covington, USA). The phyllosilicate may in particular be a hydrated phyllosilicate, such as Optigel WX (commercially available from Byk-Chemie GmbH, Wesel, Germany). The urea may in particular be a modified urea, such as Byk-7420 ES (commercially available from Byk-Chemie GmbH, Wesel, Germany).

Without wishing to be bound to any theory, the following is assumed: Based on the theory of spray-etching, the flow of an etching composition is more turbulent in the middle or center of an etched structure so that the liquid is more agitated there than at the side walls of the structure to be etched. In this situation, the addition of a rheological additive to the etching composition may cause an increase in viscosity of the etching composition near to the side walls in comparison to the middle of the structure. As a general rule, the lower the viscosity of the etching composition, the easier a component exchange between the etching liquid and the etched surface (for instance made of copper). As a consequence, the addition of a rheological additive may result in a higher etching speed in a vertical direction and a lower etching speed in a horizontal direction, thereby further increasing the anisotropy of the etching process and the resulting etched structures.

In an embodiment, the rheological additive is contained in the etching composition in a concentration of from 0.001 g/l to 10 g/l, in particular of from 0.01 g/l to 5 g/l.

In an embodiment, the method of etching an electrically conductive layer structure of a component carrier for forming a conductor track comprises subjecting the electrically conductive layer structure to an etching composition as described herein. In particular, the method of etching may be a wet etching process.

In an embodiment, the electrically conductive layer structure is subjected to a subtractive etching procedure for forming the conductor track, in particular a subtractive wet etching procedure for forming the conductor track. Thus, the etching process may be a subtractive etching process.

In an embodiment, the subjecting the electrically conductive layer structure to the etching composition comprises a spraying the etching composition on (a surface of) the electrically conductive layer structure.

In an embodiment, subsequent to subjecting the electrically conductive layer structure to the etching composition, the (etched) electrically conductive layer structure may be subjected to a rinsing liquid.

In an embodiment, the rinsing liquid comprises a compound configured for adjusting a porosity of an etched surface and/or for protecting a (copper) surface from interaction with air (in the following referred to as "rinsing liquid additive").

In an embodiment, the rinsing liquid additive may be selected from the group consisting of ethoxylated amides, (ethoxylated) amines, fatty acids, phosphonic acid esters, alkanolamine phosphonates and dispersing agents.

In an embodiment, the conductor track is characterized in that a virtual tangent at a lower edge of a side wall of the conductor track and a virtual tangent at an upper edge of the side wall of the conductor track intersect with each other at a virtual intersection point, wherein a height of the virtual intersection point is at least 40 %, in particular at least 50 %, in particular at least 60 %, of a total height of the conductor track.

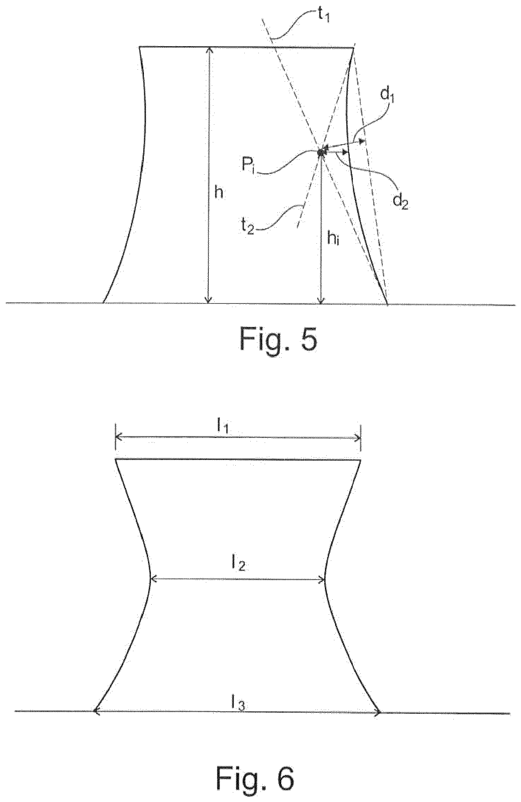

In an embodiment, the conductor track may be characterized in that a nearest distance between the virtual intersection point and a virtual line from the upper edge to the lower edge of the side wall of the conductor track is less than 30 %, in particular less than 20 %, in particular less than 10 %, of a total height of the conductor track. The "nearest distance" may in particular vertically extend from the virtual line (i.e. a virtual line from the upper edge to the lower edge of the side wall of the conductor track) to the virtual intersection point, as indicated by the arrow "di" in Figure 5.

In an embodiment, the conductor track may be characterized in that a length of a virtual horizontal line from the virtual intersection point to an adjacent side wall of the conductor track is less than 20 %, in particular less than 15 %, in particular less than 10 %, of a total height of the conductor track.

In an embodiment, the conductor track may be formed by means of an etching composition as described herein and/or by the method of etching as described herein.

In another embodiment, the conductor track is characterized by a ratio between an upper width and a central width being in a range between 1.0 and 1.3, in particular between 1.0 and 1.2, in particular between 1.0 and 1.1, and a ratio between a central width and a lower width being in a range between 0.6 and 1.0, in particular between 0.75 and 1.0, in particular between 0.9 and 1.0. In addition, the conductor track may be characterized by a ratio between an upper width and a lower width being in a range between 0.7 and 1.0, in particular between 0.8 and 1.0, in particular between 0.9 and 1.0. An "upper width" may in particular denote a length of a virtual horizontal line of the conductor track at an upper plateau (or on top) of the conductor track, as indicated by the arrow "l₁" in Figure 6. A "central width" may in particular denote a length of a virtual horizontal line of the conductor track in the middle (i.e. at a height of 50 % of the total height) of the conductor track, as indicated by the arrow "l₂" in Figure 6. A "lower width" may in particular denote a length of a virtual horizontal line of the conductor track at the bottom of the conductor track, as indicated by the arrow "l₃" in Figure 6.

In an embodiment, the conductor track may be formed by means of an etching composition as described herein and/or by the method of etching as described herein.

In an embodiment, the component carrier comprises a stack of at least one electrically insulating layer structure and at least one electrically conductive layer structure, wherein at least a part of at least one electrically conductive layer structure comprises a conductor track as described herein.

In an embodiment, the part of the at least one electrically conductive layer structure comprising the conductor track may be at least partly exposed.

In an embodiment, the part of the at least one electrically conductive layer structure comprising the conductor track may be at least partly sandwiched between two electrically insulating layers and/or at least partly embedded within one electrically insulating layer structure.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of nonconsecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photoimageable or dry-etchable organic material like epoxy-based build-up material (such as epoxy-based build-up film) or polymer compounds like polyimide, polybenzoxazole, or benzocyclobutene.

In an embodiment, the at least one electrically insulating layer structure comprises at least one of the group consisting of resin (such as reinforced or non-reinforced resins, for instance epoxy resin or bismaleimide-triazine resin), cyanate ester, polyphenylene derivate, glass (in particular glass fibers, multilayer glass, glass-like materials), prepreg material (such as FR-4 or FR-5), polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg particularly FR4 are usually preferred for rigid PCBs, other materials in particular epoxy-based build-up film or photoimageable dielectric material may be used as well. For high frequency applications, high-frequency materials such as polytetrafluoroethylene, liquid crystal polymer and/or cyanate ester resins, low temperature cofired ceramics (LTCC) or other low, very low or ultra-low DK-materials may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

In an embodiment, the at least one electrically conductive layer structure, in particular the at least one electrically conductive layer structure comprising the conductor track, comprises at least one of the group consisting of copper, aluminum, nickel and silver.

The aspects defined above and further aspects of the invention are apparent from the exemplary embodiments to be described hereinafter and are explained with reference to these exemplary embodiments.
Figure 1 illustrates a conventional isotropic copper etching process according to the prior art.
Figure 2 illustrates an ideal anisotropic copper etching process according to an exemplary embodiment of the invention.
Figure 3 illustrates a photolithographic structuring of an electrically conductive layer structure of a component carrier by means of a photoresist involving a subtractive etching process according to an exemplary embodiment of the invention.
Figure 4 represents an enlarged view of the etching step shown in Figure 3 according to an exemplary embodiment of the invention.
Figure 5 illustrates a cross-sectional view of a conductor track according to an exemplary embodiment of the invention.
Figure 6 illustrates a cross-sectional view of a conductor track according to another exemplary embodiment of the invention.
Figure 7 is a graphical illustration of experimental results of etching factor and etching homogeneity of etched structures obtained by using etching compositions according to exemplary embodiments of the invention and comparative etching compositions.
Figure 8 shows pictures of conductor tracks obtained by using etching compositions according to exemplary embodiments of the invention and comparative etching compositions.

The illustrations in the drawings are schematical. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, an etching composition is provided comprising specific additives which promote an anisotropic etching of an electrically conductive layer structure so that conductor tracks may be formed having a substantially regular shape, in particular with substantially vertical side walls.

Without wishing to be bound to any theory, it is believed that the etching additive and/or the organic substance, in particular the polymer compound comprised, may adsorb at (adhere to) the surface of the side walls of a recess (cavity) formed in the electrically conductive layer structure during etching, thereby protecting or shielding the side walls from the etchant and suppressing a further etching in a lateral direction and that the etching additive, in particular when it is has surface-active properties, may promote a material exchange during etching, may accelerate movement of bubbles from a surface and may reduce surface tension. Moreover, it is believed that the polyhydric compound may properly adjust or optimize the viscosity of the etching solution and that the polymer compound contained in the etching composition may provide for a shear thinning/pseudoplastic behavior which may further promote the anisotropy of the etching process, as explained in the following: In areas where the flow speed of the etching solution is low, which is mainly at the upper side wall of the generated flow etching channel, where the side wall (copper) surface is in a flow shadow of the photoresist, the viscosity of the etching liquid may be higher which renders the exchange of substances more difficult so that the etching process may be further slowed down in a lateral direction, while at the bottom of the generated etching channel where the flow speed is higher and more turbulent, the viscosity of the etching liquid may remain low so that the etching process may proceed in a vertical direction much faster. As a result, an etching in a vertical direction may be promoted compared with an etching in a lateral direction. Hereby, the overall quality of a component carrier, such as a printed circuit board, may be increased, in particular in terms of a decreased defect rate as well as an improved etching distribution (increased homogeneity) within the produced boards and a higher etching factor of etched structures. In addition, a line width lower than 50 µm, such as 30 µm or less, may be achieved. Moreover, the etching composition may be substantially harmless to human health and to the environment and may provide for cost benefits compared with commercially available etching solutions.

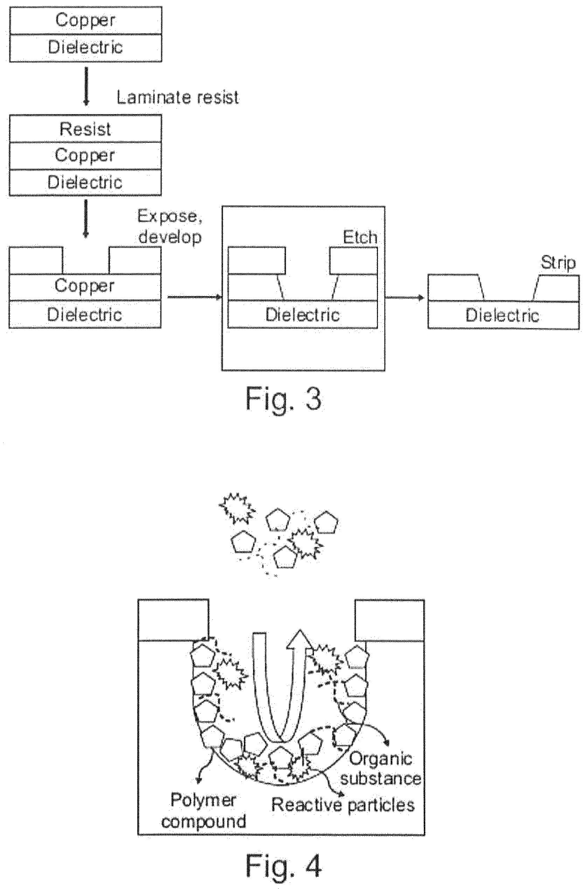

**Figure 3** illustrates a photolithographic structuring of an electrically conductive layer structure of a component carrier by means of a photoresist involving a subtractive etching process according to an exemplary embodiment of the invention. In a first step, a laminate or stack of an electrically insulating layer structure (such as made of a dielectric) and an electrically conductive layer structure (such as made of copper) to be etched is provided. Next, a photoresist layer is applied on the electrically conductive layer structure. Then, the photoresist is partly exposed (through a mask, not shown) to electromagnetic radiation (such as UV light) and developed, thereby removing that part of the photoresist that has been exposed to the electromagnetic radiation. In the next step, a subtractive etching step according to an exemplary embodiment of the method of etching of the invention is performed (highlighted by a frame). Hereby, the electrically conductive layer structure is anisotropically etched so that the side walls of a recess formed in the electrically conductive layer structure are substantially vertical, even though a slight undercut beneath the photoresist is shown in Figure 3. Finally, the remaining photoresist (such as that part of the photoresist that has not been exposed to the electromagnetic radiation before) is removed, for instance stripped off, and an arrangement of conductor tracks according to an exemplary embodiment of the invention on the dielectric is obtained.

**Figure 4** represents an enlarged view of the etching step highlighted by the frame in Figure 3 according to an exemplary embodiment of the invention. The etching composition shown in Figure 4 comprises "reactive particles" (i.e. an etchant), an organic substance (such as a polyhydric compound) and a polymer compound (as an etching additive). As can be taken from Figure 4, the polymer compound may be capable of adsorbing at the surface of the side walls, thereby shielding the side walls from the etchant and thus suppressing a further etching in a lateral direction, whereas at the bottom of the recess formed in the electrically conductive layer structure the reactive particles may come into contact with the electrically conductive material. In addition, the organic substance may properly adjust the viscosity of the etching composition. Due to a shear thinning/pseudoplastic effect of the polymer compound contained in the etching composition, in areas where the flow speed of the etching solution is low, which is mainly at the upper side wall of the recess formed in the electrically conductive layer structure, where the side wall (copper) surface is in a flow shadow of the photoresist, the viscosity of the etching liquid may be higher which renders the exchange of substances more difficult so that the etching process may be further slowed down in a lateral direction, while at the bottom of the recess formed in the electrically conductive layer structure where the flow speed is higher and more turbulent, the viscosity of the etching liquid may remain low so that the etching process may proceed in a vertical direction much faster.

Referring to **Figure 5**, a cross-sectional view of a conductor track according to an exemplary embodiment of the invention is shown. In particular, the cross-sectional view shown in Figure 5 is a cross-sectional view in vertical direction of the conductor track, i.e. a view of the conductor track when cut in a vertical direction. The conductor track according to this exemplary embodiment is characterized in that a virtual tangent t₁ at an lower edge of a side wall of the conductor track and a virtual tangent t₂ at a upper edge of the side wall of the conductor track intersect with each other at a virtual intersection point Pᵢ, wherein a height hᵢ of the virtual intersection point is at least 40 %, in particular at least 50 %, in particular at least 60 %, of a total height h of the conductor track. The conductor track may be further characterized in that a nearest distance d₁ between the virtual intersection point Pᵢ and a virtual line from the upper edge to the lower edge of the side wall of the conductor track is less than 30 %, in particular less than 20 %, in particular less than 10 %, of a total height h of the conductor track. The nearest distance d₁ vertically (perpendicularly) extends from the virtual line (from the upper edge to the lower edge of the side wall of the conductor track) to the virtual intersection point. The conductor track may be still further characterized in that a length d₂ of a virtual horizontal line from the virtual intersection point Pᵢ to an adjacent side wall of the conductor track is less than 20 %, in particular less than 15 %, in particular less than 10 %, of a total height h of the conductor track.

Referring to **Figure 6**, a cross-sectional view of a conductor track according to another exemplary embodiment of the invention is shown. In particular, the cross-sectional view shown in Figure 6 is a cross-sectional view in vertical direction of the conductor track, i.e. a view of the conductor track when cut in a vertical direction. The conductor track according to this exemplary embodiment is characterized by a ratio between an upper width l₁ and a central width l₂ being in a range between 1.0 and 1.3, in particular between 1.0 and 1.2, in particular between 1.0 and 1.1, and a ratio between a central width l₂ and a lower width l₃ being in a range between 0.6 and 1.0, in particular between 0.75 and 1.0, in particular between 0.9 and 1.0. In addition, the conductor track may be further characterized by a ratio between an upper width l₁ and a lower width l₃ being in a range between 0.7 and 1.0, in particular between 0.8 and 1.0, in particular between 0.9 and 1.0. As evident from Figure 6, the upper width l₁ represents a length of a virtual horizontal line of the conductor track at an upper plateau (or on top) of the conductor track, the central width l₂ represents a length of a virtual horizontal line of the conductor track in the middle (at a height of 50 % of the total height) of the conductor track, and the lower width l₃ represents a length of a virtual horizontal line of the conductor track at the bottom of the conductor track.

The invention is further described by the following examples and experimental results, which are solely for the purpose of illustrating specific embodiments, and are not construed as limiting the scope of the invention in any way.

### Etching compositions

Standard etching composition (Reference Example): CuCl₂, H₂O₂, H₂O, HCl
Inventive etching composition, concentration 1: CuCl₂, H₂O₂, H₂O, HCl, polymer compound, sugar alcohol
Inventive etching composition, concentration 2: CuCl₂, H₂O₂, H₂O, HCl, polymer compound (three times of concentration 1), sugar alcohol
Commercial additive etching composition (Comparative Example): CuCl₂, H₂O₂, H₂O, HCl, additive EXE-6711 from MEC Europe

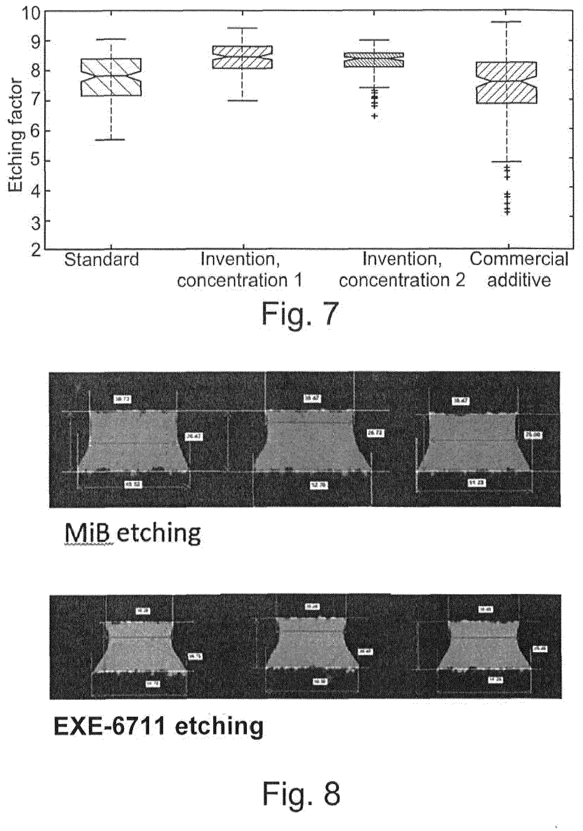

**Figure 7** is a graphical illustration of experimental results of etching factor and etching homogeneity of etched structures obtained by using etching compositions according to exemplary embodiments of the invention, more specifically inventive etching composition, concentration 1, and inventive etching composition, concentration 2 and comparative etching compositions, more specifically standard etching composition (Reference Example) and an etching composition with a commercial additive (Comparative Example) . As evident from the results shown in Figure 7, by using an etching composition according to the present invention (containing a polymer compound additive and a sugar alcohol additive), the etching factor can be improved by about 1 unit compared with a standard etching composition (without additives) and compared with a comparative etching composition (containing a commercial additive for anisotropic etching). In addition, the etching homogeneity is significantly higher for surfaces treated by an etching composition according to the present invention than with a standard or a comparative etching composition.

**Figure 8** shows pictures of conductor tracks obtained by using etching compositions according to exemplary embodiments of the invention and comparative etching compositions. In the upper row conductor tracks obtained by using etching compositions according to exemplary embodiments of the invention ("MiB etching") and in the lower row conductor tracks obtained by using comparative etching compositions ("EXE-6711 etching") are shown. As it is evident from Figure 8, a more regular shape of the etching structures can be obtained after application of an etching composition according to the invention compared with an etching composition containing a commercial additive (such as EXE-6711).

It should be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. An etching composition for etching an electrically conductive layer structure for forming a conductor track, the etching composition comprising:
an etchant;
an etching additive comprising a polymer compound;
an organic substance comprising a polyhydric compound; and
optionally a solvent.

2. The etching composition according to claim 1, wherein the etchant comprises at least one of cupric chloride (CuCl₂) and ferric chloride (FeCl₃), and optionally further comprises at least one of hydrochloric acid (HCl) and hydrogen peroxide (H₂O₂).

3. The etching composition according to claim 1 or 2, wherein the polymer compound comprises at least one of a phosphor atom, a nitrogen atom and/or a sulphur atom.

4. The etching composition according to any one of the preceding claims, wherein the polymer compound is a homopolymer having a repeating unit comprising a heterocycle.

5. The etching composition according to any one of the preceding claims, wherein the etching additive is selected from the group consisting of polyacrylamide, polyacrylic acid, polymethacrylic acid, polymethylmethacrylate, polyvinyl alcohol, polyvinyl acetate, polylactic acid, polyglycolic acid, polyvinylpyridine, polyvinylpyrrolidone, poly(N-vinylformamide), polyoxazoline, polyethylene oxide, polyetheretherketone, cellulose ether, carboxymethyl cellulose, gelatin, collagen, chitosan, and dextran.

6. The etching composition according to any one of the preceding claims, wherein the polyhydric compound comprises two, three, four, five or six carbon atoms.

7. The etching composition according to any one of the preceding claims, wherein the organic substance is selected from the group consisting of ethylene glycol, glycerin, erythritol, threitol, arabinol, xylitol, ribitol, mannitol, sorbitol, galacticol and polyglycitol.

8. The etching composition according to any one of the preceding claims, further comprising a rheological additive.

9. The etching composition according to claim 8, wherein the rheological additive is selected from the group consisting of silica, hydroxyethyl cellulose, phyllosilicates and urea.

10. A method of etching an electrically conductive layer structure of a component carrier for forming a conductor track, wherein the method comprises subjecting the electrically conductive layer structure to an etching composition according to any of claims 1 to 9.

11. The method according to claim 10, wherein the electrically conductive layer structure is made subject to a subtractive etching procedure for forming the conductor track.

12. A conductor track, wherein a virtual tangent (t₁) at a lower edge of a side wall of the conductor track and a virtual tangent (t₂) at an upper edge of the side wall of the conductor track intersect with each other at a virtual intersection point (Pᵢ), wherein a height (hᵢ) of the virtual intersection point is at least 40 % of a total height (h) of the conductor track.

13. A conductor track, wherein a ratio between an upper width (l₁) and a central width (l₂) is in a range between 1.0 and 1.3 and a ratio between a central width (l₂) and a lower width (l₃) is in a range between 0.6 and 1.0.

14. A component carrier comprising a stack of at least one electrically insulating layer structure and at least one electrically conductive layer structure, wherein at least a part of at least one electrically conductive layer structure comprises a conductor track according to claim 12 and/or 13.

15. The component carrier according to claim 14, wherein at least one of the following applies:
the component carrier further comprises at least one component being surface mounted on and/or embedded in the component carrier, wherein the at least one component is in particular selected from a group consisting of an electronic component, an electrically non-conductive and/or electrically conductive inlay, a heat transfer unit, a light guiding element, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further component carrier, and a logic chip; and/or
wherein at least one of the electrically conductive layer structures of the component carrier comprises at least one of the group consisting of copper, aluminum, nickel, silver, gold, palladium, and tungsten, any of the mentioned materials being optionally coated with supra-conductive material such as graphene; and/or
wherein the electrically insulating layer structure comprises at least one of the group consisting of resin, in particular reinforced or non-reinforced resin, for instance epoxy resin or bismaleimide-triazine resin, FR-4, FR-5, cyanate ester, polyphenylene derivate, glass, prepreg material, polyimide, polyamide, liquid crystal polymer, epoxy-based Build-Up Film, polytetrafluoroethylene, a ceramic, and a metal oxide; and/or
wherein the component carrier is shaped as a plate; and/or
wherein the component carrier is configured as one of the group consisting of a printed circuit board, a substrate, and an interposer; and/or
wherein the component carrier is configured as a laminate-type component carrier.

## Amended claims

### Amended claims in accordance with Rule 137(2) EPC.

1. An etching composition for etching an electrically conductive layer structure for forming a conductor track, wherein the etching composition is a solution and comprises:
an etchant;
an etching additive comprising a polymer compound, wherein the polymer compound comprises one or more functional groups containing a phosphor atom, a nitrogen atom and/or a sulphur atom;
an organic substance comprising a polyhydric compound; and
optionally a solvent.

2. The etching composition according to claim 1, wherein the etchant comprises at least one of cupric chloride (CuCl₂) and ferric chloride (FeCl₃), and optionally further comprises at least one of hydrochloric acid (HCl) and hydrogen peroxide (H₂O₂).

3. The etching composition according to claim 1 or 2, wherein the polymer compound is a homopolymer having a repeating unit comprising a heterocycle.

4. The etching composition according to any one of the preceding claims, wherein the etching additive is selected from the group consisting of polyacrylamide, polyvinylpyridine, polyvinylpyrrolidone, poly(N-vinylformamide), gelatin, collagen, and chitosan.

5. The etching composition according to any one of the preceding claims, wherein the polyhydric compound comprises two, three, four, five or six carbon atoms.

6. The etching composition according to any one of the preceding claims, wherein the organic substance is selected from the group consisting of ethylene glycol, glycerin, erythritol, threitol, arabinol, xylitol, ribitol, mannitol, sorbitol, galacticol and polyglycitol.

7. The etching composition according to any one of the preceding claims, further comprising a rheological additive.

8. The etching composition according to claim 7, wherein the rheological additive is selected from the group consisting of silica, hydroxyethyl cellulose, phyllosilicates and urea.

9. A method of etching an electrically conductive layer structure of a component carrier for forming a conductor track, wherein the method comprises subjecting the electrically conductive layer structure to an etching composition according to any of claims 1 to 8.

10. The method according to claim 9, wherein the electrically conductive layer structure is made subject to a subtractive etching procedure for forming the conductor track.
